Europäisches Patentamt

European Patent Office

Office européen des brevets

(11) Veröffentlichungsnummer: **0 083 068**
A1

(12) **EUROPÄISCHE PATENTANMELDUNG**

(21) Anmeldenummer: 82111894.0

(22) Anmeldetag: 22.12.82

(51) Int. Cl.³: **D 05 B 19/00**

(30) Priorität: 24.12.81 DE 3151392

(43) Veröffentlichungstag der Anmeldung:
06.07.83 Patentblatt 83/27

(84) Benannte Vertragsstaaten:
BE DE FR GB IT

(71) Anmelder: Quick-Rotan Elektromotoren GmbH
Gräfenhäuser Strasse 85
D-6100 Darmstadt(DE)

(72) Erfinder: Kothe, Peter, Dipl.-Ing.
Beerbacher Strasse 15
D-6053 Obertshausen(DE)

(72) Erfinder: Angersbach, Wolfgang, Dipl.-Ing.
Alfred-Messel-Weg 40
D-6100 Darmstadt(DE)

(72) Erfinder: Schüler, Peter
Lortzingstrasse 21
D-6053 Oberthausen(DE)

(74) Vertreter: Schwan, Gerhard, Dipl.-Ing.
Elfenstrasse 32
D-8000 München 83(DE)

(54) Drehzahlgeregelter Nähantrieb.

(57) Drehzahlgeregelter Nähantrieb mit einem Drehstrommotor, einer mit der Abtriebsseite des Motors verbundenen Regelkupplung, einem Steuerkasten mit ansteckbarer Elektronikplatte, und einem Positionsgeber. Zur leichten und flexiblen Anpassung des Nähantriebs an alle in der Praxis in Verbindung mit unterschiedlichen Maschinentypen auftretenden Anforderungen ist auf der Elektronikplatte ein für eine Vielzahl von Nähprogrammen ausgelegtes Mikroprozessorsystem angebracht, und die Elektronikplatte trägt mindestens ein Auswahlelement zum wahlweisen Freischalten des jeweils gewünschten Nähprogramms.

./...

FIG. 1

P-134

Quick-Rotan

Elektromotoren GmbH

Gräfenhäuser Str.85

6100    D a r m s t a d t


Drehzahlgeregelter Nähantrieb


Die Erfindung betrifft einen drehzahlgeregelten Nähantrieb mit einem Drehstrommotor, einer mit der Abtriebsseite des Motors verbundenen Regelkupplung, einem Steuerkasten mit ansteckbarer Elektronikplatte, und einem Positionsgeber.

Als Positionierantrieb ausgelegte Nähantriebe dieser Art sind aus der DE-OS 29 30 228 bekannt. Beim praktischen Einsatz solcher Nähantriebe ergeben sich Probleme daraus, daß in der industriellen Nähtechnik die verschiedenartigsten Bedingungen bezüglich der durchzuführenden Näharbeiten und Nähprogramme, der in Verbindung mit dem Antrieb anzusteuernden Zusatzfunktionseinheiten, der Art der Positionierung und dergleichen mehr gestellt werden. Diesbezügliche Unterschiede bestehen nicht nur zwischen den Maschinen verschiedener Nähmaschinenherstellen, sondern auch innerhalb der Typenreihen ein und derselben Nähmaschinenproduzenten. Infolgedessen ist es bisher notwendig, eine größere Anzahl unterschiedlicher Steuerungen zu fertigen und auf Lager zu halten. Auch die Wartung wird dadurch erschwert.

Der Erfindung liegt die Aufgabe zugrunde, einen universell einsetzbaren Nähantrieb zu schaffen, d.h. einen Nähantrieb, der sich allen Kundenwünschen auf besonders einfache und kostensparende Weise anpassen läßt.

Diese Aufgabe wird erfindungsgemäß dadurch gelöst, daß auf der Elektronikplatte ein für eine Vielzahl von Nähprogrammen ausgelegtes Mikroprozessorsystem angebracht ist, und daß die Elektronikplatte außerdem mindestens ein Auswahlelement zum wahlweisen Freischalten des jeweils gewünschten Nähprogramms trägt.

Auf diese Weise lassen sich praktisch alle bekannten, in der Nähtechnik verwendeten Funktionsabläufe berücksichtigen und durch entsprechendes Einsetzen des oder der Auswahlelemente abrufen. Durch bloßes Umsetzen, z.B. Umstecken, eines oder mehrerer Auswahlelemente lassen sich so mit einem einzigen Motortyp und einer einzigen standardisierten Steuerung alle Forderungen erfüllen, um jede Maschinenklasse eines oder mehrerer Hersteller bedienen zu können. Daneben gibt die erfindungsgemäße Lösung dem Benutzer die Möglichkeit, mit dem erfindungsgemäßen Einheitsantrieb lediglich durch Austausch der vorprogrammierten und gegebenenfalls entsprechend eingestellten Elektronikplatte mehrere beim Benutzer vorhandene unterschiedliche Nähmaschinen-Oberteile wahlweise zu betreiben. Es wird also ein Höchstmaß an Flexibilität und Anpassungsfähigkeit erreicht. Der Einheitsantrieb läßt sich in großen Stückzahlen besonders preiswert herstellen.

Auf der Elektronikplatte können in weiterer Ausgestaltung der Erfindung Steckverbindungsglieder, insbesondere Steckbuchsen, für Positionsgeber, Drehzahlsollwertgeber, das Kupplungssystem und bestimmte Maschinenfunktionen angebracht sein. Auf der Elektronikplatte sitzen ferner zweckmäßig Timerpotentiometer, die durch Ausnehmungen eines Steuerkastendeckels hindurch bedienbar sind. Auf diese Weise lassen sich unterschiedliche
Timerzeiten einstellen, um beispielsweise bestimmte Positionierprogramme, Fadenabschneidprogramme, Verriegelungsprogramme oder dergleichen durchzuführen. Ein Drehzahlsollwertgeber ist vorzugsweise außen am Steuerkasten abnehmbar
angebracht. Dadurch kann der Drehzahlsollwertgeber, falls
erwünscht, an vom Nähantrieb entfernter Stelle angeordnet
und mit der Elektronikplatte über ein Verlängerungskabel
verbunden werden.

Die Elektronikplatte kann des weiteren eine Steckbuchse zum
Anschluß einer Fernbedienungseinheit tragen, mit der sich
beispielsweise Maschinenfunktionen von der Näherin wahlweise ändern lassen.

Die Erfindung ist im folgenden anhand eines bevorzugten Ausführungsbeispiels näher erläutert. In den beiliegenden Zeichnungen zeigen:

Fig. 1          eine Seitenansicht eines erfindungsge-
                mäßen drehzahlgeregelten Nähantriebs,

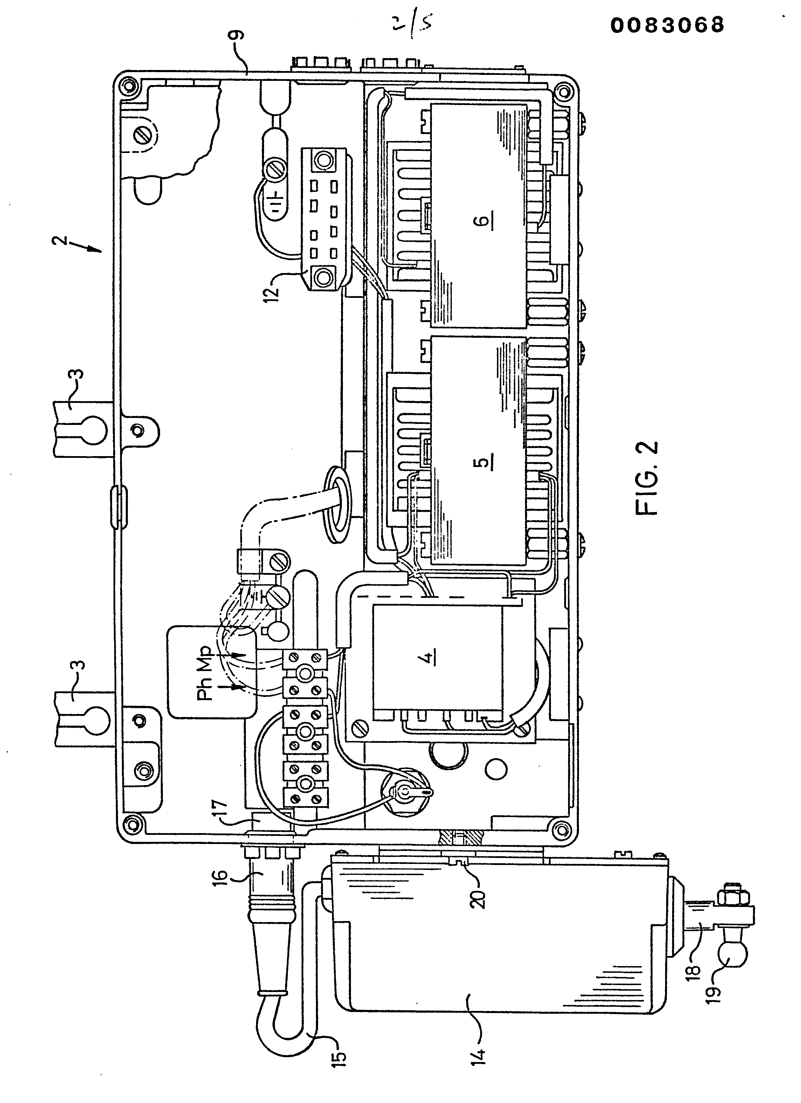

Fig. 2          eine Ansicht des Steuerkastens und des
                Drehzahlsollwertgebers bei abgenommenem
                Deckel und herausgezogener Elektronikplatte,

Fig. 3          eine Draufsicht auf die Elektronikplatte,

Fig. 4          eine Draufsicht auf die Steckerplatte
                des Steuerkastens nach Fig. 1,

Fig. 5          einen Schnitt durch eine Fernbedienungseinheit entsprechend der Linie 5-5 der
                Fig. 6, und

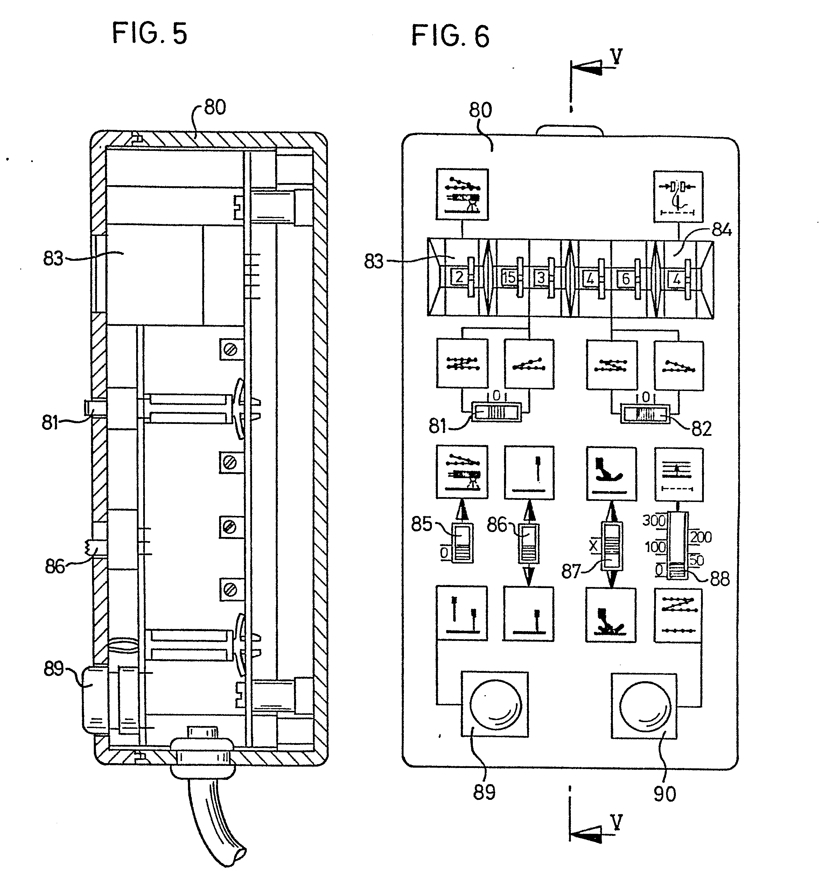

Fig. 6                          eine Draufsicht auf die Fernbedienungseinheit nach Fig. 5.


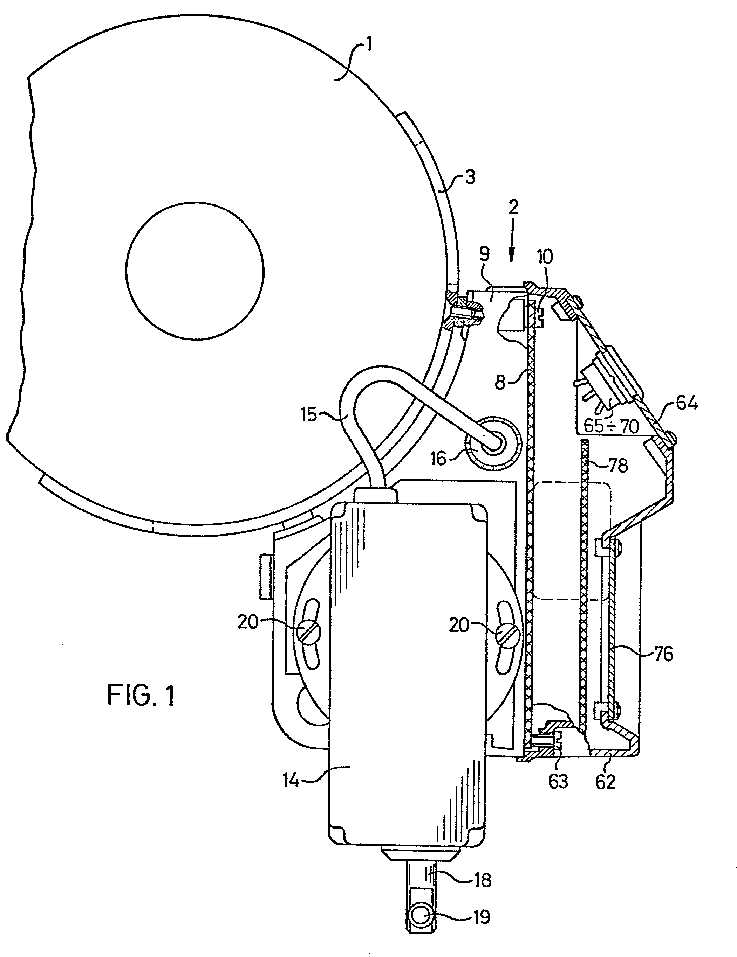

Der in Fig. 1 veranschaulichte Nähantrieb weist einen nur
schematisch angedeuteten Drehstrommotor 1 mit einer angeflanschten (nicht dargestellten) Regelkupplung auf. Anordnungen dieser Art sind beispielsweise aus den US-PSn
3,487,438, 3,532,953, 3,761,790, 4,172,985 und 4,228,385
bekannt und bedürfen infolgedessen vorliegend keiner weiteren Erläuterung.

Mit dem Motor 1 ist ein Steuerkasten 2 über Schellen 3 verbunden. In dem Steuerkasten 2 ist ein Netzteil untergebracht,
zu dem u.a. Netztrafos 4, 5 und 6 gehören. Beispielsweise
lassen sich aus dem Netztrafo 4 die Elektronikbausteine der
Steuerung speisen, während die Netztrafos 5 und 6 für die
Speisung des Kupplungsteils und des Bremsteils der Regelkupplung vorgesehen sein können.

Eine Elektronikplatte 8 ist auf das Unterteil 9 des Steuerkastens 2 lösbar aufgesetzt. Die Elektronikplatte 8 wird mit
dem Unterteil 9 über Schrauben 10 verbunden. Dabei wird eine
auf der Elektronikplatte 8 befestigte Steckerleiste 11 mit
einer im Steuerkastenunterteil 9 untergebrachten Steckerbuchsenleiste 12 in Eingriff gebracht. Über die Bauteile 11, 12
werden auf diese Weise die vom Netzteil angelieferten Betriebsspannungen auf die Elektronikplatte 8 selbsttätig durchgeschaltet, sobald die Elektronikplatte 8 in den Steuerkasten
2 eingesetzt wird.

Ein Drehzahlsollwertgeber 14 ist außen am Steuerkasten 2 abnehmbar angebracht. Der Sollwertgeber 14 kann beispielsweise
in der aus der DE-OS 30 03 138 bekannten Weise aufgebaut sein.
Er ist über ein Anschlußkabel 15 und einen Stecker 16 an eine Steckerbuchse 17 des Steuerkastenunterteils 9 anschließbar und steht andererseits über eine Zug/Schubstange 18 und ein Kugelgelenk 19 über ein nicht dargestelltes Gestänge mit dem Pedal der anzutreibenden Nähmaschine in Verbindung. Die lösbare Verbindung des Drehzahlsollwertgebers 14 mit dem Steuerkasten erfolgt beispielsweise über Schrauben 20. Sie gestattet es, den Sollwertgeber 14 im Bedarfsfall vom Steuerkasten zu trennen und an zweckentsprechender anderer Stelle anzuordnen. In einem solchen Fall braucht zwischen Stecker 16 und Steckerbuchse 17 nur ein Verlängerungskabel eingefügt zu werden.

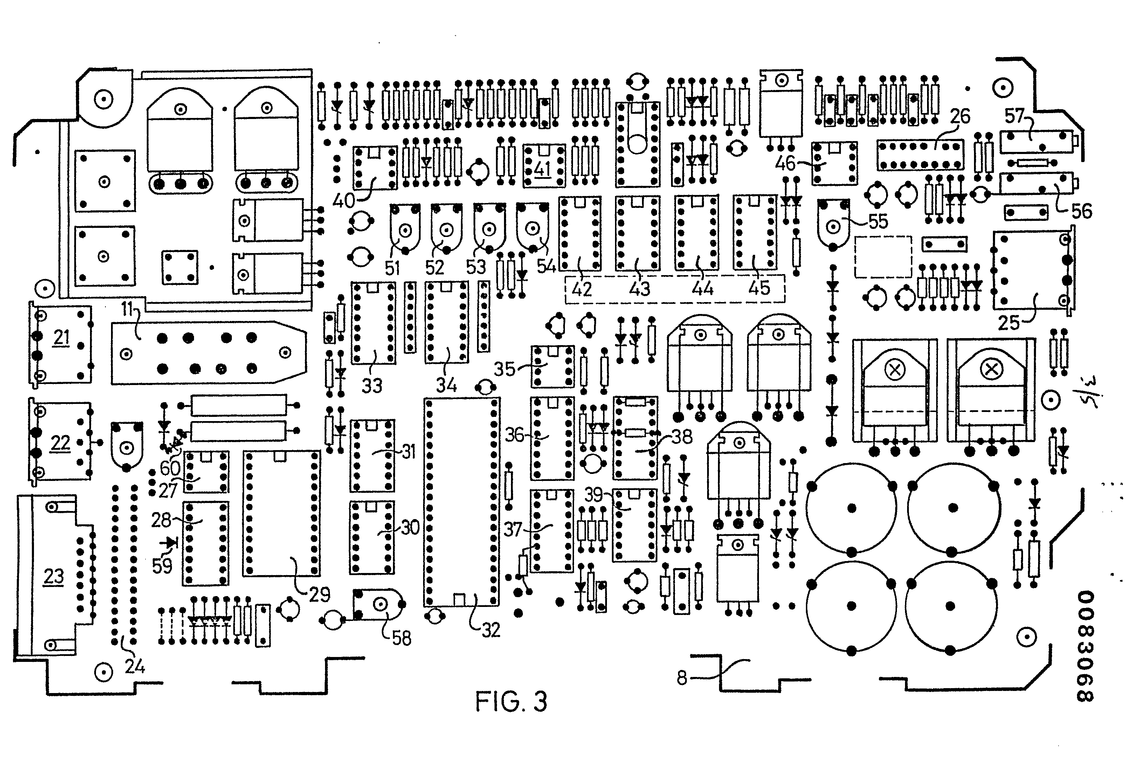

Die im einzelnen in Fig. 3 veranschaulichte Elektronikplatte 8 trägt neben der Steckerleiste 11 und einer Gruppe von Steckbuchsen 21, 22, 23, 24, 25 und 26 für den Anschluß eines mit der Nähmaschinenhauptwelle in Antriebsverbindung stehenden Positionsgebers, der die Winkelstellung der Nähmaschinenhauptwelle mindestens in den wichtigen Grundstellungen wie "Nadel oben" und "Nadel unten" erfaßt, den Sollwertgeber 14, die Regelkupplung des Motors 1, bestimmte Maschinenfunktionseinheiten, wie Fadenabschneidvorrichtung, Stichsteller (zum Umstellen des Stofftransports von vorwärts auf rückwärts und umgekehrt), Drückerfußbetätigung, Fadenwischer usw., sowie für den Anschluß einer Fernbedienungseinheit 80. Auf der Elektronikplatte 8 sitzt ferner ein Mikroprozessorsystem, zu dem insbesondere Elektronikbausteine (integrierte Schaltungen) 27 bis 46 gehören. Die Elektronikplatte 8 ist des weiteren mit Potentiometern 51 bis 58 zum Einstellen von Timerzeiten bestückt, die es gestatten, die bei Nähantriebssteuerungen vorkommenden Betätigungs- und Wartezeiten nach Wunsch und in Abhängigkeit von dem jeweils mit dem Antrieb verbundenen Nähmaschinentyp vorzugeben.

Das Mikroprozessorsystem enthält ein Universalprogramm für
alle Nähvorgänge zweckmäßig aller bekannter Nähmaschinen.
Auswahlelemente 59, 60, bei der vorliegenden Ausführungsform in Gestalt von Dioden, lassen sich auf der Elektronikplatte 8 in Abhängigkeit von dem jeweils gewünschten Programm einsetzen, um dadurch das Programm für einen bestimmten Maschinentyp freizuschalten. Die Anpassung des Nähantriebs an den jeweiligen Nähmaschinentyp geschieht also in
einfachster Weise dadurch, daß die Auswahlelemente 59, 60
(und gegebenenfalls weitere Auswahlelemente) in spezieller
Konfiguration umgesteckt werden. Es braucht also keine gesonderte Steuerung für jeden einzelnen Nähmaschinentyp aufgebaut und auf Lager gehalten zu werden. Vielmehr wird die
vorliegende Anordnung als Universalantrieb mit wenigen einfachen Handgriffen an die jeweilige Maschinentype und die
gewünschten Funktionsabläufe adaptiert. Dies führt zu außerordentlicher Vereinfachung und entscheidenden Kostenvorteilen.

Auf das Unterteil 9 des Steuerkastens 2 ist ein Deckel 62
aufgesetzt, der mit dem Unterteil beispielsweise über Schrauben 63 verbunden ist.

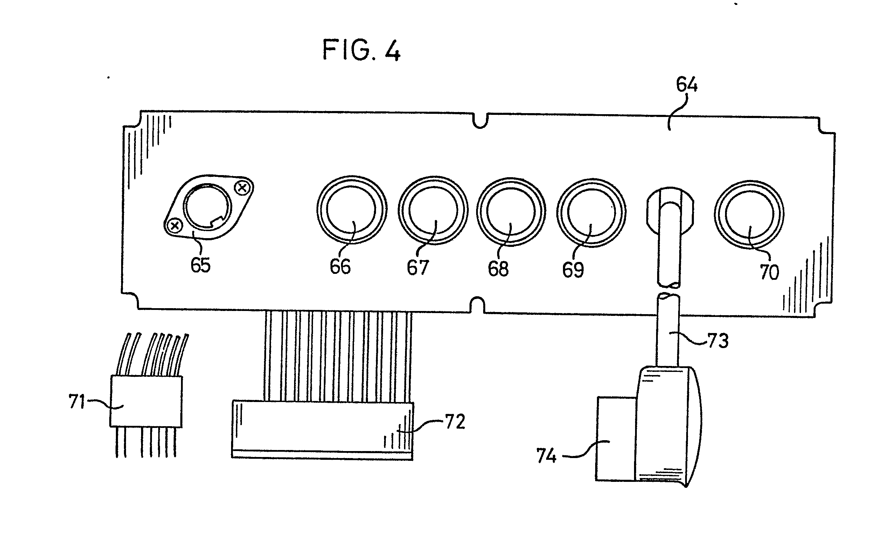

Der Deckel 62 trägt eine Steckerplatte 64 (vergleiche auch
Fig. 4). Auf der Steckerplatte 64 sind Steckbuchsen 65 bis
70 befestigt, die dem Anschluß der Steuerung an die zu betätigenden Funktionseinheiten dienen und die ihrerseits mit
der Elektronikplatte 8 über Stecker 71, 72 und die Steckbuchsen 25, 26 verbunden sind. Ein Kabel 73 mit Steckverbindungsglied 74 führt zu dem Drückerfußmagnet. Der Positionsgeber
wird an die Steckbuchse 22 angeschlossen.

Auf einer gleichfalls mit dem Deckel 62 verbundenen Schalterplatte 76 sitzen Schalter (nicht im einzelnen veranschaulicht)
zum Aufschalten von Funktionen wie "Nadel oben", "Nadel unten",
Riegelart für Anfangs- und Endriegel, für vorbestimmte Solldrehzahlen und dergleichen. Die Schalter der Schalterplatte 76
sind an die Steckbuchse 24 der Elektronikplatte 8 über einen
zugehörigen Stecker angeschlossen. Die Potentiometer 51 bis
58 der Elektronikplatte 8 sind durch entsprechende Ausnehmungen im Deckel 62 hindurch zugänglich. In diese Ausnehmungen
(nicht veranschaulicht) sind zweckmäßig Führungsbuchsen eingesetzt, die ein sicheres Führen des zum Verstellen der betreffenden Potentiometer verwendeten Werkzeugs gewährleisten.
Bei der Ausführungsform nach Fig. 1 ist im Steuerkasten 2
schließlich noch eine Steuerplatte 78 untergebracht, die weitere Elektronikbauteile und/oder Steuerglieder aufnehmen
kann.

In den Fign. 5 und 6 ist eine Fernbedienungseinheit 80 dargestellt, die beispielsweise zur Aufnahme aller Stellglieder und Schalter geeignet ist, wie sie auch auf der Schalterplatte 76 des Steuerkastens 2 angebracht sind. Beispielsweise sind in Fig. 6 Wählschalter 81, 82 für die Auswahl der
Verriegelungsart am Anfang und am Ende der Naht, Wähl- und
Anzeigeglieder 83, 84 für die Riegelstichzahlen und für die
Nahtlänge, Schalter 85, 86, 87 und 88 für Sonderfunktionen
sowie Drucktasten 89, 90 zum Nadelhochfahren und Riegelaustasten
dargestellt. Die Fernbedienungseinheit 80 läßt sich an die
Buchse 23        der Elektronikplatte 8 anschließen, wenn
es erwünscht ist, auf bequeme Weise Maschinenfunktionen von
einer vom eigentlichen Antrieb entfernten Stelle aus einstellen und ändern zu können.

**0083068**

Die mit dem Drehstrommotor 1 verbundene Regelkupplung
weisst vorzugsweise, wie an sich bekannt, eine Reibungskupplung und eine Reibungsbremse auf, die über eine
PLL—Elektronik geregelt werden. Diese PLL-Elektronik und
das Mikroprozessorsystem können in der in den DE-OSn
29 38 040 und 30 11 587 bekannten Weise aufgebaut sein.

P-134

Quick-Rotan

Elektromotoren GmbH

Gräfenhäuser Str.85

6100 D a r m s t a d t

A n s p r ü c h e :

1. Drehzahlgeregelter Nähantrieb mit einem Drehstrommotor, einer mit der Abtriebsseite des Motors verbundenen Regelkupplung, einem Steuerkasten mit ansteckbarer Elektronikplatte, und einem Positionsgeber, dadurch gekennzeichnet, daß auf der Elektronikplatte (8) ein für eine Vielzahl von Nähprogrammen ausgelegtes Mikroprozessorsystem (27 bis 45) angebracht ist, und daß die Elektronikplatte außerdem mindestens ein Auswahlelement (59, 60) zum wahlweisen Freischalten des jeweils gewünschten Nähprogramms trägt.

2. Nähantrieb nach Anspruch 1, dadurch gekennzeichnet, daß auf der Elektronikplatte (8) Steckverbindungsglieder (21 bis 26) für einen Positionsgeber, einen Drehzahlsollwertgeber (14), die Regelkupplung und vorgegebene Maschinenfunktionseinheiten angebracht sind.

3. Nähantrieb nach Anspruch 1 oder 2, dadurch gekennzeichnet, daß auf der Elektronikplatte (8) Timerpotentiometer (51 bis 58) angebracht sind und der Steuerkasten (2) einen Deckel (62) mit Ausnehmungen aufweist, durch die hindurch die Potentiometer von außen bedienbar sind.

4. Nähantrieb nach einem der vorhergehenden Ansprüche, dadurch gekennzeichnet, daß ein Drehzahlsollwertgeber (14) außen am Steuerkasten (2) abnehmbar angebracht ist.

5. Nähantrieb nach einem der vorhergehenden Ansprüche, dadurch gekennzeichnet, daß die Elektronikplatte (8) eine Steckbuchse zum Anschluß einer Fernbedienungseinheit (80) trägt.

FIG. 1

FIG. 2

Ph Mp

2

3

3

9

16

17

12

15

14

20

18

19

4

5

6

2/5

0083068

FIG. 3

0083068

3/5

# FIG. 4

FIG. 5

FIG. 6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| X,D | FR-A-2 478 341  (QUICK-ROTAN) <br> * Seite 14, Zeilen 7-13; Figur 2 * | 1 | D 05 B  19/00 |
| X | DE-A-2 646 831  (TOSHIBA) <br> * Seite 14, Zeilen 7-24; Figuren 2,4 * | 1 | |
| A,D | FR-A-2 462 811  (QUICK-ROTAN) <br> * Insgesamt * | 2,5 | |
| A,D | GB-A-2 068 028  (QUICK-ROTAN) <br> * Seite 1, Zeilen 53-97; Figur 3 * | 4 | |
| A | SIEMENS ZEITSCHRIFT, Band 46, Heft 4, 1972, Seiten 283-285, Erlangen, DE. <br> G. ENGELHARD et al.: "Frontplatten-Einbauelemente des FEE-Systems" * SEite 284, Zeilen 29-47; Figur 4 * | 3 | RECHERCHIERTE SACHGEBIETE (Int. Cl. 3) <br><br> H 02 P <br> G 05 B <br> G 06 F <br> G 05 D <br> D 05 B |
| A | US-A-3 976 981  (ROSEMOUNT) <br> * Spalte 7, Zeilen 24-55; Figuren 2,3 * | 1 | |
| D,A | FR-A-2 374 765  (QUICK-ROTAN) | 1 | |
| D,A | US-A-3 532 953  (QUICK-ROTAN) | 1 | |

-/-

Der vorliegende Recherchenbericht wurde für alle Patentansprüche erstellt.

| Recherchenort DEN HAAG | Abschlußdatum der Recherche 06-04-1983 | Prüfer HOUILLON J.C.P.L. |
|---|---|---|

## EINSCHLÄGIGE DOKUMENTE

Seite 2

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| D,A | FR-A-2 374 770   (QUICK-ROTAN) | 1 | |
| | --- | | |
| D,A | US-A-3 487 438   (QUICK-ROTAN) | 1 | |
| | --- | | |
| D,A | US-A-3 761 790   (QUICK-ROTAN) | 1 | |
| | ----- | | |

**RECHERCHIERTE SACHGEBIETE (Int. Cl. ³)**

Der vorliegende Recherchenbericht wurde für alle Patentansprüche erstellt

| Recherchenort DEN HAAG | Abschlußdatum der Recherche 06-04-1983 | Prüfer HOUILLON J.C.P.L. |
|---|---|---|